# EUROPÄISCHE PATENTSCHRIFT

(11) **EP 3 587 617 B1**
(45) Veröffentlichungstag und Bekanntmachung des Hinweises auf die Patenterteilung: **05.08.2020**
(21) Anmeldenummer: 19190316.0
(22) Anmeldetag: 12.06.2013
(51) Int. Cl.: C23C 14/00, C23C 14/08, C23C 14/02, G01J 5/34, H01L 37/02, H01L 37/04, H01L 41/316

(54) **VERFAHREN ZUM HERSTELLEN EINES MIKROSYSTEMS MIT EINER DÜNNSCHICHT AUS BLEIZIRKONATTITANAT**
METHOD FOR PRODUCING A MICROSYSTEM COMPRISNG A LAYER OF LEAD ZIRCONATE TITANATE
PROCÉDÉ DE FABRICATION D'UN MICROSYSTÈME COMPRENANT UNE COUCHE DE ZIRCONATE TITANATE DE PLOMB

(30) Priorität: 12.06.2012 DE 102012105036
(43) Veröffentlichungstag der Anmeldung: 01.01.2020
(62) Teilanmeldung aus: 13728730.6
(73) Patentinhaber: Pyreos Ltd., Edinburgh EH9 3JF (GB)
(72) Erfinder: GIEBELER, Carsten, Edinburgh, EH32 0PE (GB); SCHREITER, Matthias, 81379 München (DE); STEINKOPFF, Thorsten, 85658 Egmating (DE); WERSING, Wolfram, 83346 Bergen (DE)
(74) Vertreter: Mewburn Ellis LLP

(56) Entgegenhaltungen:
- WO-A1-00/17921
- DE-B3-102011 000 752
- ADACHI M ET AL: "Sputter-Deposition of [111]-Axis Oriented Rhombohedral PZT Films and Their Dielectric, Ferroelectric and Pyroelectric Properties", JAPANESE JOURNAL OF APPLIED PHYSICS, Bd. 26, Nr. 4, April 1987 (1987-04), Seiten 550-553, XP055077256, Japan Society of Applied Physics, Tokyo [JP] ISSN: 0021-4929, DOI: 10.1143/JJAP.26.550
- SCHREITER M ET AL: "Sputtering of self-polarized PZT films for IR-detector arrays", PROCEEDINGS OF THE ELEVENTH IEEE INTERNATIONAL SYMPOSIUM ON APPLICATIONS OF FERROELECTRICS (ISAF 98), MONTREUX [CH], 24. August 1998 (1998-08-24), - 27. August 1998 (1998-08-27), Seiten 181-185, XP010347216, IEEE, Piscataway, NJ [US] ISSN: 1099-4734, DOI: 10.1109/ISAF.1998.786665 ISBN: 978-0-7803-4959-9
- Abdel-Baset M A Ibrahim ET AL: "Morphotropic Phase Boundary in Ferroelectric Materials" In: "Ferroelectrics - Physical Effects", 23. August 2011 (2011-08-23), InTech, Rijeka [HR], XP055240706, ISBN: 978-953-30-7453-5 Seiten 1-26, DOI: 10.5772/17206, * Abbildung 1 *

## Beschreibung

Die Erfindung betrifft ein Verfahren zum Herstellen eines Mikrosystems.

Dünnschichten aus Bleizirkonattitanat (PZT) sind aufgrund ihrer vorteilhaften physikalischen Eigenschaften, wie beispielsweise einer hohen elektromechanischen Kopplung, einer hohen Dielektrizitätszahl oder einem hohen pyroelektrischen Koeffizienten, in der Mikrosystemtechnik weit verbreitet. Ein Mikrosystem weist herkömmlich ein Substrat als einen Träger für die Dünnschicht auf, wobei das Substrat in der Regel aus Silizium hergestellt ist. In der Dünnschicht liegt das Bleizirkonattitanat als ein Mischkristall vor, der je nach Zirkongehalt eine entsprechend unterschiedliche Kristallsymmetrie hat. Zirkonarmes Bleizirkonattitanat liegt vorrangig in der tetragonalen Phase vor, wohingegen zirkonreiches Bleizirkonattitanat vorrangig in der rhomboedrischen Phase vorliegt. Hat das Bleizirkonattitanat eine morphotrope Zusammensetzung, beispielsweise mit einem Zirkongehalt bei etwa 50%, liegen gleichzeitig tetragonale und rhomboedrische Gefügebestandteile insbesondere als Körner in der Dünnschicht vor. Es ist bekannt, die Bleizirkonattitanat-Dünnschicht mit einem Abscheideverfahren, insbesondere einem Sputter-Prozess, auf das Substrat aufzubringen, wobei die Dünnschicht typischerweise (111)-texturiert vorliegt. Das heißt, die (111)-Richtungen aller Körner der Dünnschicht liegen nahezu parallel zur Flächennormalen der Substratoberfläche vor.

Aus der Publikation ADACHI M ET AL: "Sputter-Deposition of [111]-Axis Oriented Rhombohedral PZT Films and Their Dielectric, Ferroelectric and Pyroelectric Properties", JAPANESE JOURNAL OF APPLIED PHYSICS, Bd. 26, Nr. 4, April 1987 (1987-04), Seiten 550 - 553, XP055077256, Japan Society of Applied Physics, Tokyo [JP] ISSN: 0021-4929, DOI: 10.1143/JJAP.26.550 ist es bekannt, [111]-orientierte Dünnschichten aus rhomboedrischem Bleizirkonattitanat (PZT) epitaktisch auf platinbeschichteten Saphirsubstraten durch Magnetronsputtern in sauerstoffhaltiger Atmosphäre abzuscheiden. Die Substrattemperatur beträgt 610 °C. Ein pyroelektrischer Koeffizient von 3·10⁻⁹ C/cm²K bei Raumtemperatur wird erreicht.

Aus der Publikation DE 10 2011 000752 B3 ist ein Verfahren zum Herstellen des Dünnfilms aus Blei-Zirkonat-Titanat in 111-orientierter Perovskit-Struktur bekannt, aufweisend die Schritte: Bereitstellen eines Substrats mit einer Substrattemperatur von über 450°C und eines Blei-Targets, eines Zirkon-Targets und eines Titan-Targets; Aufbringen des Dünnfilms durch Sputtern von Blei, Zirkon und Titan von den jeweiligen Targets auf das Substrat, wobei die gesamte Abscheiderate von Blei, Zirkon und Titan größer als 10 nm/min ist, die Abscheiderate von Zirkon derart gewählt wird, dass die atomare Konzentration von Zirkon bezogen auf die atomare Konzentration von Zirkon zusammen mit Titan im Dünnfilm zwischen 0,2 und 0,3 liegt, und die Abscheiderate von Blei in Abhängigkeit der Substrattemperatur und der gesamten Abscheiderate von Blei, Zirkon und Titan so niedrig gewählt wird, dass ein Röntgendiffraktometerdiagramm des 111-orientierten Blei-Zirkonat-Titanats im Bereich des Beugungswinkels von 33 bis 35,5° einen signifikanten Spitzenwert hat; und Fertigstelle des Dünnfilms.

Aus der Publikation WO 00/17921 A1 ist ein Verfahren zur Herstellung selbstpolarisierter ferroelektrischer Schichten bekannt, insbesondere PZT-Schichten, mit rhomboedrischer Kristallstruktur, gekennzeichnet durch folgende Schritte: a) Bereitstellen eines Substrats und Erwärmen des Substrats auf eine Temperatur T1; b) Aufbringen einer Schicht mit rhomboedrischer Kristallstruktur, die eine metallarme, selbstpolarisierte Schicht mit einer Curie-Temperatur TC1 und eine metallreiche Schicht mit einer Curie-Temperatur TC2 aufweist, auf das Substrat, wobei gilt: T1 > TC1 > TC2; c) Beenden der Erwärmung des Substrats und Abkühlen der Schicht mit rhomboedrischer Kristallstruktur nach Beendigung des Aufbringvorgangs.

Für die makroskopische piezo- bzw. pyroelektrische Funktionalität der Bleizirkonattitanat-Dünnschicht ist eine Vorzugsrichtung der Polarisierung notwendig, wobei die optimale Ausrichtung der Vorzugsrichtung der Polarisierung vom jeweiligen gewünschten physikalischen Effekt, der mit der Dünnschicht erzielt werden soll, wie beispielsweise dem pyroelektrischen Effekt, abhängt. Zur Optimierung des pyroelektrischen Effekts ist die Vorzugsrichtung der Polarisierung der Dünnschicht möglichst parallel zur Oberflächennormalen der Substratoberfläche ausgerichtet. Da in der rhomboedrischen Phase die spontane Polarisation einer Gitterzelle in (111)-Richtung liegt, bietet an sich eine (111)-texturierte Dünnschicht die Vorrausetzungen für eine bezüglich des pyroelektrischen Effekts optimale Ausrichtung der Polarisation.

Der pyroelektrische Effekt der Dünnschicht wird durch den pyroelektrischen Koeffizienten der Dünnschicht definiert. Die Größe des pyroelektrischen Koeffizienten der Dünnschicht ist im Wesentlichen von der Zusammensetzung der Bleizirkonattitanat-Dünnschicht abhängig. Ist die Dünnschicht zirkonarm, liegt die Dünnschicht nach ihrer Deposition und Abkühlung auf Raumtemperatur in einer selbstpolarisierten Form vor. Das heißt, die beim Abscheiden des Bleizirkonattitanats gewachsene (111)-orientierte Dünnschicht ändert ihren Polarisationszustand nicht mehr bei der sich anschließenden Abkühlung. Im Gegensatz dazu verliert die Dünnschicht, die reich an Zirkon ist, die Selbstpolarisation während der Abkühlung. Dieser Verlust der Selbstpolarisation erweist sich insofern als nachteilig, als für (111)-orientierte rhomboedrische Bleizirkonattitanat-Dünnschichten aufgrund der optimalen Ausrichtung der Polarisation ein deutlich höherer pyroelektrischer Effekt als bei tetragonaler Zusammensetzung der Dünnschicht zu erwarten ist. Die Herstellung von selbstpolarisiertem Bleizirkonattitanat ist beschrieben in M. Schreiter, R. Bruchhaus, D. Pitzer and W. Wersing, "Sputtering of self-polarised PZT films for IR detector arrays", Proceedings of ISAF XI, 1998.

Ist beispielsweise ein Infrarotlichtsensor auf Basis der Bleizirkonattitanat-Dünnschicht aufgebaut, geht die Größe des pyroelektrischen Koeffizienten der Dünnschicht linear in die Stärke des Sensorausgangssignals ein, so dass bei Erzielen des starken pyroelektrischen Effekts eine hohe Empfindlichkeit des Sensors erreichbar ist. Somit kommen für den Infrarotlichtsensor mit der hohen Sensorempfindlichkeit lediglich Bleizirkonattitanat-Dünnschichten in Frage, die einen geringen Anteil an Zirkon aufweisen.

Aufgabe der Erfindung ist es ein Verfahren zur Herstellung eines Mikrosystems mit einem Substrat und einer Dünnschicht aus Bleizirkonattitanat sowie einen Infrarotlichtsensorchip mit dem Mikrosystem zu schaffen, wobei das Mikrosystem eine hohe Funktionalität hat.

Die Aufgabe wird gelöst mit den Merkmalen der Patentansprüche 1 und 7. Bevorzugte Ausgestaltungen dazu sind in den weiteren Patentansprüchen angegeben.

Das erfindungsgemäße Verfahren zum Herstellen des Mikrosystems weist die Schritte auf: Bereitstellen eines Substrats aus Aluminiumoxid; Herstellen einer Dünnschicht auf dem Substrat durch Abscheiden von Bleizirkonattitanat auf das Substrat mit einem thermischen Abscheideverfahren derart, dass das Bleizirkonattitanat in der Dünnschicht selbstpolarisiert ist und vorwiegend in der rhomboedrischen Phase vorliegt; Abkühlen des Substrats mit der Dünnschicht. Der erfindungsgemäße Infrarotlichtsensorchip weist das Mikrosystem auf.

Das Bleizirkonattitanat hat einen pyroelektrischen Koeffizienten von größer als 1,3^{∗}10⁻⁴ C/Km². Bevorzugtermaßen ist das Abscheideverfahre ein
Sputterprozess oder ein Laserablationsprozess. Das Abscheideverfahren ist bevorzugt ein Co-Dispositionsprozess mit drei individuellen Targets jeweils für Blei, Zirkon und Titan. Der Zirkongehalt des Bleizirkonattitanats in der Dünnschicht liegt bevorzugt im Bereich der morphotropen Phasengrenze. Besonders bevorzugt ist es, dass der Zirkongehalt des Bleizirkonattitanats in der Dünnschicht zwischen 40% und 50% liegt. Die Substrattemperatur ist bevorzugtermaßen größer als 500°C. Es ist bevorzugt, dass das Bleizirkonattitanat in sauerstoffhaltiger Atmosphäre abgeschieden wird. Ferner weist das Substrat auf dessen Oberseite eine Schicht aus Platin auf, auf die das Bleizirkonattitanat abgeschieden wird. Außerdem ist es bevorzugt, dass das Substratmaterial Saphir ist. Die Oberseite des Substrats ist poliert, auf der die Dünnschicht aufgebracht wird.

Tetragonales (111)-texturiertes Bleizirkonattitanat und rhomboedrisches (111)-texturiertes Bleizirkonattitanat haben ein unterschiedliches Verhalten bezüglich der Umorientierung der Polarisation von Domänen. In der rhomboedrischen Phase ist die (111)-Kristallrichtung die Richtung der spontanen Polarisation, wodurch die Ausrichtung von Domänen unter zwei unterschiedlichen Winkeln zur Oberflächennormalen des Substrats erlaubt ist. In der tetragonalen Phase hingegen bildet eine (001)-Kristallrichtung die Richtung der spontanen Polarisation. Für die Dünnschicht, die die (111)-orientierte Kristallrichtung hat, existiert damit nur ein einziger möglicher Winkel der Domänenausrichtung zur Oberflächennormalen des Substrats.

Mit dem erfindungsgemäßen Verfahren wird erreicht, dass in der Dünnschicht des Mikrosystems das Bleizirkonattitanat in rhomboedrischer Form vorliegt, wobei das Bleizirkonattitanat selbstpolarisiert ist und einen hohen pyroelektrischen Koeffizienten von größer als 1,3^{∗}10⁻⁴ C/ Km² hat. Dadurch hat das Mikrosystem eine hohe Funktionalität. Im Fall von pyroelektrischen Anwendungen der Dünnschicht ist aufgrund der optimalen Ausrichtung der Polarisation ein vorteilhaft starker pyroelektrischer Effekts erzielt. Die Schicht aus Platin, die zwischen dem Substrat und der Dünnschicht vorgesehen wird, zum Beispiel zum Verwenden als eine Elektrode, hat keinen negativen Einfluss auf den erfindungsgemäß erzielten Effekt.

Im Folgenden wird die Erfindung anhand einer bevorzugten Ausführungsform mit Bezugnahme auf die schematischen Zeichnungen erläutert.

Es zeigen:
Figur 1 einen Querschnitt durch einen Infrarotlichtsensorchip und
Figur 2 ein Diagramm, in dem pyroelektrische Koeffizienten von Dünnschichten in Abhängigkeit von deren Zirkongehältern gezeigt sind.

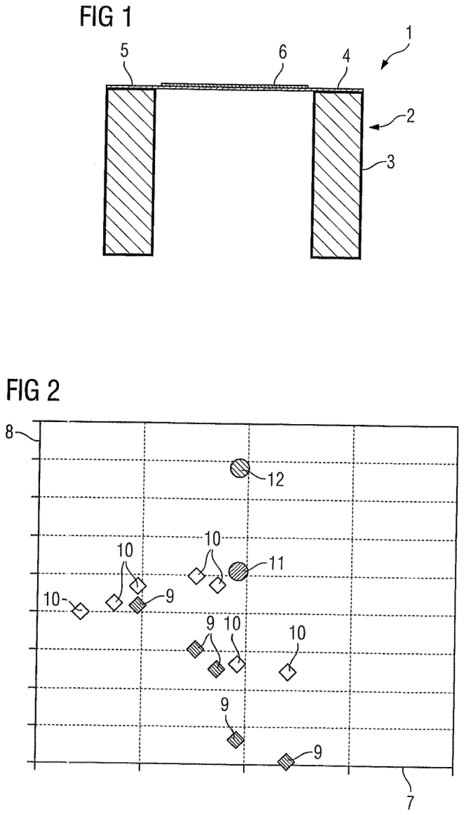

Wie es aus Figur 1 ersichtlich ist, ist ein Infrarotlichtsensorchip 1 als ein Mikrosystem ausgebildet. Der Infrarotlichtsensorchip 1 weist ein Substrat 2 auf, das von einem Rahmen 3 und einer Membran 4 gebildet ist. Der Rahmen 3 ist an der der Membranoberseite 5 abgewandten Seite angeordnet, wobei auf die Membranoberseite 5 eine Dünnschicht 6 aufgebracht ist. Die Membranoberseite 5 ist poliert. Das Dünnschichtmaterial, von dem die Dünnschicht 6 gebildet ist, ist Bleizirkonattitanat. Das Bleizirkonattitanat liegt in der Dünnschicht 6 überwiegend in der rhomboedrischen Phase vor, wobei der Zirkongehalt in der Dünnschicht etwa bei 50% liegt. Das Bleizirkonattitanat ist mit einem thermischen Abscheideverfahren, insbesondere einem Sputter-Verfahren, auf die Membranoberseite 5 aufgebracht. Ferner ist das Bleizirkonattitanat selbstpolarisiert und hat einen pyroelektrischen Koeffizienten von größer als 1,3^{∗}10⁻⁴ C/ Km². Zwischen der Dünnschicht 6 und dem Substrat 2 ist eine Elektrodenschicht aus Platin vorgesehen, die als eine Elektrode des Infrarotlichtsensorchips 1 dient. Die Außenseite der Elektrodenschicht des Substrats 2 ist poliert. Das Substratmaterial, das das Substrat 2 bildet, ist Saphir. Zur Herstellung des Substrats 2 ist ein Verfahren der 3D- Laserstrukturierung denkbar, beispielsweise mittels seines Picosekunden-Lasers. Es ist denkbar, dass das Substratmaterial amorph, polykristallin oder einkristallin vorliegt.

Das Mikrosystem wird in einer Sputterdepositionsanlage hergestellt, die geeignet ist den Sputter-Prozess durchzuführen. Das Substrat 2 ist in der Sputterdepositionsanlage mit einer Temperatur größer als 500°C in einer sauerstoffhaltigen Atmosphäre bereitzustellen. Die Sputterdepositionsanlage weist drei individuelle Targets jeweils für Blei, Zirkon und Titan auf, wobei die Sputterdeposition einen Zirkongehalt des Bleizirkonattitanats in der Dünnschicht erzeugt, der im Bereich der morphotropen Phasengrenze und besonders bevorzugt zwischen 40% und 50% liegt. Nach Beenden der Sputterdeposition wird das Mikrosystem mit dem Substrat 2 zusammen mit der Dünnschicht 6 auf Umgebungstemperatur abgekühlt.

Nach dem Abkühlvorgang liegt das Bleizirkonattitanat in der Dünnschicht 6 des Mikrosystems in rhomboedrischer Form vor, wobei das Bleizirkonattitanat selbstpolarisiert ist und einen pyroelektrischen Koeffizienten von größer als 1,3^{∗}10⁻⁴ C/ Km² hat. Dadurch hat die Dünnschicht 6 einen starken pyroelektrischen Effekt und somit hat das Mikrosystem eine hohe Funktionalität. Dies ist insbesondere für die Verwendung des Bleizirkonattitanats für die Dünnschicht 6 in dem Infratotlichtsensorchip 1 vorteilhaft. Das Vorsehen der Elektrodenschicht hat keinen Einfluss auf die Stärke des pyroelektrischen Effekts.

Figur 2 zeigt ein Diagramm, in dem die Stärke des pyroelektrischen Effekts von Dünnschichten von Infrarotlichtsensorchips gezeigt ist, wobei der pyroelektrische Effekt von den Infrarotlichtsensorchips mit einem Substrat aus Silizium und von den Infrarotlichtsensorchips mit einem Substrat aus Saphir verglichen wird. Mit dem Bezugszeichen 7 ist die Abszisse des Diagramms gekennzeichnet, auf der der relative Zirkongehalt im Bleizirkonattitanat als Zr/(Zr+Ti) aufgetragen ist. Ferner ist in dem Diagramm mit dem Bezugszeichen 8 die Ordinate gekennzeichnet, auf der der pyroelektrische Koeffizient Pk des Bleizirkonattitanats aufgetragen ist.

Mit dem Bezugszeichen 9 sind Eintragungen gekennzeichnet, die Infrarotlichtsensorchips mit einem Silizium-Substrat mit einer Bleizirkonattitanat-Dünnschicht ohne zusätzlicher Polarisation zuzuordnen sind und mit dem Bezugszeichen 10 sind Eintragungen gekennzeichnet, die Infrarotlichtsensorchips mit einem Silizium-Substrat mit einer Bleizirkonattitanat-Dünnschicht mit zusätzlicher Polarisation zuzuordnen sind. Die Bezugszeichen 11 und 12 kennzeichnen Infrarotlichtsensorchips mit jeweils einem Saphir-Substrat mit einer Bleizirkonattitanat-Dünnschicht ohne bzw. mit zusätzlicher Polarisation. Die Eintragungen im Diagramm zeigen, dass bereits im selbstpolarisierten Zustand von den Infrarotlichtsensorchips mit dem Saphir-Substrat alle herkömmlich erreichten Werte des pyroelektrischen Koeffizienten der Infrarotlichtsensorchips mit dem Silizium- Substrat deutlich übertroffen werden. Für die zusätzlich gepolten Dünnschichten ergibt sich eine deutliche Erhöhung des pyroelektrischen Koeffizienten auf mehr als das 1,5-fache verglichen mit dem herkömmlich mit den Silizium-Substraten erreichten Maximalwert.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Ansprüche zu verlassen.

### Bezugszeichenliste

- 1: Infrarotlichtsensorchip
- 2: Substrat
- 3: Rahmen
- 4: Membran
- 5: Membranoberseite
- 6: Dünnschicht
- 7: Abszisse: Zr/(Zr+Ti)
- 8: Ordinate Pk
- 9: Silizium-Substrat mit Bleizirkonattitanat-Dünnschicht ohne zusätzlicher Polarisation
- 10: Silizium-Substrat mit Bleizirkonattitanat-Dünnschicht mit zusätzlicher Polarisation
- 11: Saphir-Substrat mit Bleizirkonattitanat-Dünnschicht ohne zusätzlicher Polarisation
- 12: Saphir-Substrat mit Bleizirkonattitanat-Dünnschicht mit zusätzlicher Polarisation

## Patentansprüche

1. Verfahren zum Herstellen eines Mikrosystems, mit den Schritten:
Bereitstellen eines Substrats (2) aus Aluminiumoxid;
Herstellen einer Dünnschicht (6) auf dem Substrat (2) durch Abscheiden von Bleizirkonattitanat auf das Substrat (2) mit einem thermischen Abscheideverfahren derart, dass das Bleizirkonattitanat in der Dünnschicht (6) selbstpolarisiert ist und vorwiegend in der rhomboedrischen Phase vorliegt,
wobei das Substrat (2) auf dessen Oberseite (5) eine Schicht aus Platin aufweist, auf die das Bleizirkonattitanat abgeschieden wird;
wobei das Bleizirkonattitanat einen pyroelektrischen Koeffizienten von größer als 1,3^{∗}10⁻⁴ C/Km² hat;
wobei die Oberseite (5) des Substrats (2), auf der die Schicht aus Platin ausgebildet ist, poliert ist, und
Abkühlen des Substrats (2) mit der Dünnschicht (6).

2. Verfahren gemäß Anspruch 1, wobei das Abscheideverfahren ein Sputterprozess oder ein Laserablationsprozess ist.

3. Verfahren gemäß einem der Ansprüche 1 oder 2, wobei das Abscheideverfahren ein Co-Dispositionsprozess mit drei individuellen Targets jeweils für Blei, Zirkon und Titan ist.

4. Verfahren gemäß einem der Ansprüche 1 bis 3, wobei der Zirkongehalt des Bleizirkonattitanats in der Dünnschicht (6) zwischen 40% und 50% liegt.

5. Verfahren gemäß einem der Ansprüche 1 bis 4, wobei das Bleizirkonattitanat in sauerstoffhaltiger Atmosphäre abgeschieden wird.

6. Verfahren gemäß einem der Ansprüche 1 bis 5, wobei das Substratmaterial Saphir ist.

7. Infrarotlichtsensorchip mit einem Mikrosystem, das gemäß einem der Ansprüche 1 bis 6 hergestellt ist.

## Claims

1. Method for producing a microsystem, with the steps:
providing a substrate (2) of aluminium oxide;
producing a thin layer (6) on the substrate (2) by depositing lead zirconate titanate onto the substrate (2) with a thermal deposition process in such a way that the lead zirconate titanate in the thin layer (6) is self polarised and is present predominantly in the rhombohedral phase, in which the substrate (2) has a layer of platinum on its upper side (5), onto which the lead zirconate titanate is deposited;
in which the lead zirconate titanate has a pyroelectrical coefficient greater than 1.3^{∗}10⁻⁴ C/Km²;
in which the upper side (5) of the substrate (2), on which the layer of platinum is formed, is polished, and
cooling the substrate (2) with the thin layer (6).

2. Method according to claim 1, in which the deposition process is a sputter process or a laser ablation process.

3. Method according to one of claims 1 or 2, in which the deposition process is a codeposition process with three individual targets for lead, zirconium and titanium respectively.

4. Method according to one of claims 1 to 3, in which the zirconium content of the lead zirconate titanate in the thin layer (6) is between 40% and 50%.

5. Method according to one of claims 1 to 4, in which the lead zirconate titanate is deposited in an atmosphere containing oxygen.

6. Method according to one of claims 1 to 5, in which the substrate material is sapphire.

7. Infrared light sensor chip with a microsystem, which is produced according to one of claims 1 to 6.

## Revendications

1. Procédé de fabrication d'un microsystème, comprenant les étapes suivantes :
préparation d'un substrat (2) en oxyde d'aluminium ;
réalisation d'une couche mince (6) sur le substrat (2) par dépôt de titanate-zirconate de plomb sur le substrat (2) avec un procédé de dépôt thermique de telle sorte que le titanate-zirconate de plomb est auto-polarisé dans la couche mince (6) et se présente principalement dans la phase rhomboédrique, le substrat (2) présentant sur son côté supérieur (5) une couche de platine sur laquelle le titanate-zirconate de plomb est déposé ;
le titanate-zirconate de plomb ayant un coefficient pyroélectrique supérieur à 1,3^{∗}10⁻⁴ C/Km² ;
le côté supérieur (5) du substrat (2) sur lequel est constituée la couche de platine étant poli, et
refroidissement du substrat (2) comportant la couche mince (6).

2. Procédé selon la revendication 1, le procédé de dépôt étant un procédé de pulvérisation ou un procédé d'ablation laser.

3. Procédé selon l'une des revendications 1 ou 2, le procédé de dépôt étant un procédé de co-disposition avec trois cibles individuelles respectivement pour le plomb, le zircon et le titane.

4. Procédé selon l'une des revendications 1 à 3, la teneur en zircon du titanate-zirconate de plomb dans la couche mince (6) étant comprise entre 40 % et 50 %.

5. Procédé selon l'une des revendications 1 à 4, le titanate-zirconate de plomb étant déposé dans une atmosphère contenant de l'oxygène.

6. Procédé selon l'une des revendications 1 à 5, le matériau du substrat étant du saphir.

7. Puce de capteur infrarouge avec un microsystème qui est réalisé selon l'une des revendications 1 à 6.
